# FASCICULE DE BREVET EUROPEEN

(11) **EP 4 377 995 B1**
(45) Date de publication et mention de la délivrance du brevet: **08.10.2025**
(21) Numéro de dépôt: 22754351.9
(22) Date de dépôt: 19.07.2022
(51) Int. Cl.: H01L 23/62, H03K 17/082, H02H 5/00, H02H 3/06

(54) **SYTÈME ÉLECTRONIQUE POUR APPLICATIONS SPATIALES**
SYSTEM FÜR WELTRAUMANWENDUNGEN
ELECTRONIC SYSTEM FOR SPACE APPLICATIONS

(30) Priorité: 30.07.2021 FR 2108362
(43) Date de publication de la demande: 05.06.2024
(73) Titulaire: Airbus Defence and Space SAS, 31402 Toulouse Cedex 4 (FR)
(72) Inventeur: BUGAUT, Vincent, 31402 Toulouse Cedex 4 (FR); CHAPELET, Tony, 31402 Toulouse Cedex 4 (FR); DAM, Quang duc, 31402 Toulouse cedex 4 (FR)
(74) Mandataire: Ipside
(86) Numéro de dépôt international: PCT/EP2022/070144
(87) Numéro de publication internationale: WO 2023/006495

(56) Documents cités:
- EP-A1- 3 125 389
- EP-A2- 0 524 724
- WO-A1-2005/119777
- WO-A1-2021/084073
- CN-B- 103 208 301
- CN-B- 106 655 078
- US-A- 5 672 918
- US-B1- 7 489 136
- DANTE DEL CORSO ET AL: "Design of a University Nano-Satellite: the PiCPoT Case", IEEE TRANSACTIONS ON AEROSPACE AND ELECTRONIC SYSTEMS, IEEE SERVICE CENTER, PISCATAWAY, NJ, US, vol. 47, no. 3, 1 July 2011 (2011-07-01), pages 1985 - 2007, XP011369270, ISSN: 0018-9251, DOI: 10.1109/TAES.2011.5937278
- LONGDEN L ET AL: "HYBRID DETECTOR PROTECTS CIRCUITS FROM RADIATION", EDN ELECTRICAL DESIGN NEWS.(TEXAS INSTRUMENT), REED BUSINESS INFORMATION, HIGHLANDS RANCH, CO, US, vol. 30, no. 19, 1 August 1985 (1985-08-01), pages 133 - 138, 140, XP000764083, ISSN: 0012-7515

## Description

### Domaine technique de l'invention

La présente invention concerne un système électronique spatial configuré pour résister aux radiations spatiales. Plus particulièrement, l'invention se rapporte à un système électronique spatial capable de détecter un évènement singulier sur un circuit électronique causé par des radiations spatiales et d'y réagir en conséquence.

### Technique antérieure

Les systèmes spatiaux, définis selon la ligne de Karman comme des systèmes fonctionnant à plus de cent kilomètres d'altitude, évoluent en environnement radiatif. Cet environnement radiatif est en particulier caractérisé par la présence de deux types de particules : des protons et des ions lourds. Ces particules chargées provoquent des effets dénommés effets singuliers sur les composants électroniques embarqués au sein de tels systèmes.

La réduction des dimensions et paramètres électriques des transistors des composants électroniques embarqués au sein des systèmes spatiaux, rend ces composants de plus en plus sensibles aux perturbations de type radiations spatiales entrainant des évènements singuliers couramment dénommés selon l'acronyme anglo-saxon SEE (Single Event Effects). Ces évènements sont la conséquence d'une impulsion de courant résultant de l'impact dans des zones sensibles du circuit intégré, de particules énergétiques présentes dans l'environnement dans lequel ils fonctionnent. Parmi les différents types d'évènements singuliers, peuvent être mentionnés notamment, l'évènement singulier de verrouillage, dénommés selon l'acronyme anglo-saxon SEL (Single Event Latch Up), qui donnent lieu à des courts-circuits masse-alimentation et peuvent donc conduire à la destruction du circuit intégré par sur-courant, induisant un effet thermique ou encore une électromigration ; l'évènement singulier de destruction, couramment dénommé selon l'acronyme anglo-saxon SEB (Single Event Burnout), qui peut conduire à la destruction d'un composant électronique de puissance suite à l'emballement thermique résultant de la combinaison du déclenchement d'un transistor bipolaire parasite d'un composant électronique de puissance et du déclenchement du mécanisme d'avalanche entrainant un effet multiplicateur du courant électrique à l'intérieur de matériaux initialement isolant du composant électronique de puissance; l'évènement singulier de rupture de grille, couramment dénommé selon l'acronyme anglo-saxon SEGR (Single Event Gate Rupture), qui peut conduire à la destruction d'un composant à effet de champs à grille isolée due au claquage de l'oxyde de grille induit par le passage d'une unique particule tel un ion lourd, un proton ou un neutron, ou encore un évènement de perturbation par une particule isolée couramment dénommé selon l'acronyme anglo-saxon SEU (Single event upset). Cet évènement de perturbation par une particule isolée est un changement d'état provoqué par une seule particule ionisante frappant un nœud sensible dans un dispositif microélectronique, comme dans un microprocesseur, une mémoire à semi-conducteur, ou des transistors de puissance. Le changement d'état est le résultat de la charge libre créée par ionisation dans ou à proximité d'un nœud important d'un élément logique. L'erreur de la donnée de sortie causée par cet impact est appelée perturbation par une particule isolée.

Les effets singuliers ont pour conséquence un risque d'endommagement voir de destruction de composants électroniques embarqués au sein de tels systèmes réduisant la durée de vie des systèmes. La probabilité de ce risque est liée d'une part à la sensibilité intrinsèque du composant aux protons et aux ions lourds, et d'autre part à l'usage qui est fait du composant, en particulier la tension d'alimentation, la température, et de manière non-générique la durée d'utilisation et la localisation en orbite pendant l'utilisation, l'utilisation étant définie ici comme la période durant laquelle le composant est alimenté électriquement.

A cet effet, il est connu de concevoir des systèmes électroniques pour les systèmes spatiaux comportant au moins un circuit intégré sensible, le circuit intégré sensible comportant une sensibilité aux radiations spatiales provoquant des évènements singuliers, par exemple un circuit intégré de type microcontrôleur ou de type « réseaux logiques programmables » dénommé communément selon l'acronyme anglo saxon FPGA (Field Programmable Gate Arrays) comprenant un circuit électronique additionnel de surveillance du circuit intégré sensible, ou encore appelé circuit compagnon du circuit intégré sensible. Le circuit compagnon est capable de couper l'alimentation du circuit intégré sensible en cas de détection d'un SEE.

Il est connu également de pouvoir tester les solutions existantes. Une solution connue consiste à exposer un composant électronique potentiellement sensible aux radiations spatiales à une source de proton et une source d'ions lourds afin de pouvoir confirmer ou infirmer la sensibilité du composant électronique, et donc des composants électroniques issus du même lot de fabrication; caractériser le cas échéant cette sensibilité et établir le cas échéant un indice partiel de fiabilité court-terme de l'efficacité du circuit compagnon par la vérification d'absence de défaillances pouvant être causées par des évènements singuliers dans les fonctionnalités du composant. L'exposition à la source d'ions lourds précitée capable de déclencher un évènement singulier de manière exhaustive, nécessite l'ouverture du boîtier du composant électronique sous test, ou l'amincissement de la puce électronique sur les composants de type flip-chip. Plus particulièrement de manière industrielle, on parlera d'exposition à une source d'ions lourds à pénétration limitée, c'est à dire pénétrant de quelques dizaines de micromètres dans les couches de silicium des puces électroniques. Un exemple d'installation permettant de générer ces ions lourds à pénétration limitée est la ligne d'ions lourds de l'université catholique de Louvain (UCL) qui ne pénètrent dans le silicium que de 50 µm à 60 MeV.cm2/mg en ion Xe.

Cependant les solutions mises en place ne permettent pas de pouvoir éviter de manière déterministe les effets des évènements singuliers même si on y intègre un dispositif spécifique lors de sa conception. Les solutions mises en place ne permettent également pas de garantir de manière industrielle efficace, c'est-à-dire selon des contraintes de temps, de coût et de risque, la durée de vie du composant électronique sensible muni d'un circuit compagnon et embarqué au sein d'un système spatial. Les raisons de cette problématique sont du fait notamment de l'ouverture et l'amincissement du composant réduisant la capacité du composant à dissiper la chaleur produite lors de son fonctionnement nominal et empêchent son utilisation de manière représentative. De plus, en cas de conclusion négative du test de durée de vie, on ne se sait pas distinguer la part de l'échec due à l'ouverture du boîtier du composant électronique sous test, ou l'amincissement de la puce électronique sur les composants de type flip-chip, et la part d'échec due à un évènement singulier provoqué par l'exposition aux radiations de protons et d'ions lourds.

### Présentation de l'invention

La présente invention vise à remédier à ces inconvénients avec une approche totalement novatrice.

A cet effet, selon un premier aspect, la présente invention se rapporte à un système électronique spatial selon la revendication indépendante 1.

Ce dispositif est avantageux pour les circuits comportant à la fois un port d'entrée de signal et un port de sortie de signal, tels que par exemple les composants de puissance, en particulier les dispositifs de régulation et de stabilisation.

L'invention est mise en œuvre selon les modes de réalisation et les variantes exposées ci-après, lesquelles sont à considérer individuellement ou selon toute combinaison techniquement opérante.

Avantageusement, le système électronique peut comprendre au moins un interrupteur d'arrêt agencé électriquement en parallèle avec l'au moins un interrupteur de protection connecté électriquement entre la masse électrique du système électronique spatial et au moins un des ports de sortie de signal du circuit électronique sensible, l'unité de traitement de signal étant configurée pour commuter l'interrupteur d'arrêt à la masse électrique lors d'une mise hors service du circuit électronique sensible. L'au moins un interrupteur d'arrêt peut comporter un transistor bipolaire configuré pour être commuté d'un état électrique bloqué à un état électrique passant en un temps supérieur à cent microsecondes, préférentiellement supérieur à une milliseconde.

Avantageusement, l'unité électronique de détection de radiations spatiales peut comprendre un dispositif électronique de surveillance du courant électrique du port d'entrée de signal. Avantageusement, l'unité électronique de détection de radiations spatiales peut comprendre un dispositif électronique de surveillance de tension électrique du port de sortie de signal.

Avantageusement, l'au moins un interrupteur de protection peut comporter un transistor à effet de champs ou un montage en Darlington de deux transistors bipolaires. Le montage en Darlington est intéressant pour les composants à faible consommation.

Avantageusement, l'au moins un interrupteur de protection est configuré pour être commuté d'un état électrique bloqué à un état électrique passant en un temps de moins de cent microsecondes, de préférence moins de dix microsecondes.

Avantageusement, l'au moins un port d'entrée de signal peut être un rail d'alimentation électrique du circuit électronique sensible.

Selon un second aspect, la présente invention se rapporte à une méthode de protection du circuit électronique sensible du système électronique spatial décrit ci-dessus, la méthode de protection comprenant les étapes de : détection d'une amplitude du signal représentative de la quantité de radiations spatiales supérieure à un seuil de radiation prédéfini ; et de commutation à la masse électrique desdits au moins un interrupteur de protection.

Avantageusement, la méthode de protection peut comprendre une étape de coupure des alimentations électriques du circuit électronique sensible, de préférence cette étape de coupure précédant l'étape de commutation à la masse électrique du au moins un interrupteur de protection.

Selon un troisième aspect, la présente invention se rapporte à une méthode de test garantissant une durée de vie prédéfinie du système électronique spatial décrit ci-dessus, la méthode de test comportant les étapes au sol de : envoi d'ions lourds pénétrants ou de rayonnement pénétrant apte à créer du latch-up sur le circuit électronique sensible ; tests fonctionnels du système électronique spatial suite à l'étape d'envoi d'ions lourds pénétrants ou de rayonnement pénétrant, pendant une durée prédéterminée et sous contrainte thermique représentatives d'un vieillissement accéléré équivalent à la durée de vie prédéfinie du système électronique spatial embarqué à bord d'un satellite en orbite terrestre.

Avantageusement, la méthode de test peut comprendre de plus les étapes au sol de : acquisition du nombre de commutation de l'état bloqué à l'état passant d'au moins un interrupteur de protection durant l'étape d'envoi ; comparaison du nombre de commutation acquis avec un nombre prédéfini de commutations à la masse électrique représentatif d'un nombre estimatif de commutations à la masse électrique pouvant se déclencher durant la durée de vie prédéfinie du système électronique dans son environnement spatial ; si le nombre de commutation acquis est inférieur au nombre prédéfini de commutations, commutation répétée et complémentaire aux commutations de l'au moins un interrupteur de protection durant l'étape d'envoi d'ion lourds pénétrants ou de rayonnement pénétrant, jusqu'à un nombre prédéfini de commutations à la masse électrique représentatif d'un nombre estimatif de commutations à la masse électrique pouvant se déclencher durant la durée de vie prédéfinie du système électronique dans son environnement spatial.

Cette méthode de test se fait préférentiellement sur un composant qui n'a été ni dépourvu de son boitier de protection ni aminci dans le cas d'un composant de type puce retournée (flip chip). Autrement dit le test se fait dans la configuration hardware prévue pour être embarquée sur satellite.

L'invention est mise en œuvre selon les modes de réalisation et les variantes exposées ci-après, lesquelles sont à considérer individuellement ou selon toute combinaison techniquement opérante.

Avantageusement, la méthode de test peut comprendre de plus une étape de détermination de l'état des structures du circuit électronique sensible par imagerie du circuit électronique sensible suite à l'étape d'envoi d'impulsions d'ions lourds pénétrants ou de rayonnement pénétrant.

WO 2021/084073 A1 divulgue un circuit de protection d'un circuit électronique sensible aux rayonnements ionisants.

### Brève description des figures

D'autres avantages, buts et caractéristiques de la présente invention ressortent de la description qui suit faite, dans un but explicatif et nullement limitatif, en regard des dessins annexés, dans lesquels :
[Fig.1] est une représentation schématique d'un système électronique spatial selon un premier mode de réalisation.
[Fig.2] est une représentation schématique détaillée d'une portion analogique du système électronique spatial selon un premier mode de réalisation.
[Fig.3] est une représentation schématique détaillée d'une portion analogique du système électronique spatial selon un second mode de réalisation.
[Fig.4] 4 est une représentation schématique de chronogrammes de commutations des interrupteurs du système électronique spatial de la figure 1.
[Fig.5] est une représentation schématique d'un système électronique spatial selon un second mode de réalisation.
[Fig.6] est une représentation d'un organigramme d'une méthode de protection d'un circuit électronique spatial sensible aux radiations spatiales.
[Fig.7] est une représentation d'un organigramme d'une méthode garantissant la robustesse aux radiations spatiales du système électronique de protection selon l'invention.

### Description des modes de réalisation

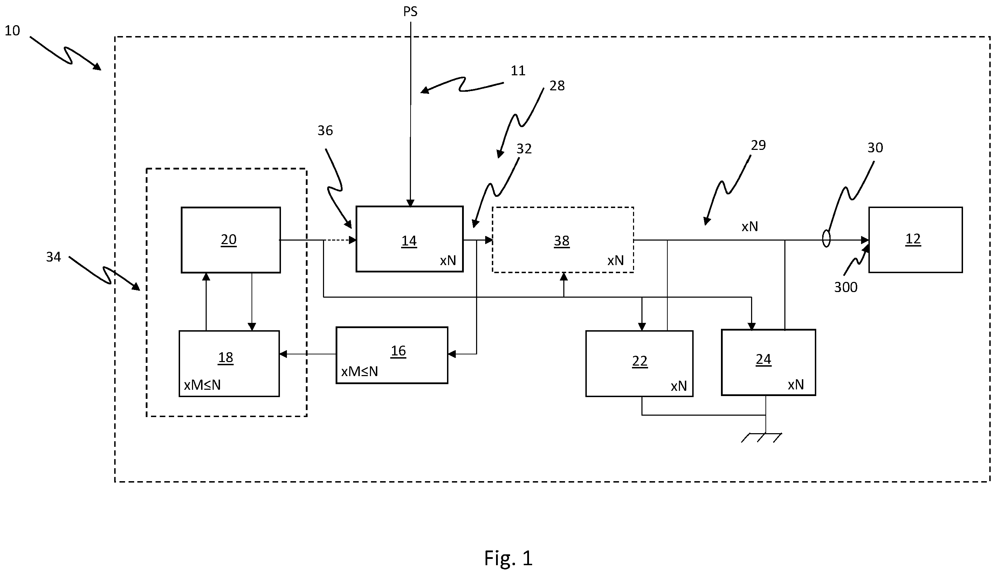

Selon la figure 1, un premier mode de réalisation d'un système électronique 10 spatial comportant un circuit électronique sensible 12, configuré pour être embarqué à bord d'un satellite est représenté. Le circuit électronique sensible 12, est, de par sa conception, intrinsèquement sensible aux bombardements de particules énergétiques présentes dans l'espace. Plus particulièrement, le circuit électronique sensible 12 est configuré pour être opérationnel dans un environnement radiatif caractérisé par la présence de protons et d'ions lourds pouvant générer des évènements singuliers entraînant l'endommagement ou la destruction du circuit électronique sensible 12. Plus particulièrement, l'endommagement du circuit électronique sensible 12 peut causer une perte de fiabilité du système électronique ne permettant plus de garantir une durée de vie du système électronique 10 conforme aux attentes, c'est-à-dire par exemple et de manière non limitative, une durée de vie de dix ans du système électronique 10 embarqué dans un satellite évoluant en orbite terrestre.

Le circuit électronique sensible 12 comporte au moins un port d'entrée 300 de signal tel que par exemple une entrée d'alimentation électrique, connectée électriquement au rail d'alimentation 30, configurée pour distribuer une alimentation électrique à divers blocs électroniques du circuit électronique sensible 12. De manière générale, le circuit électronique sensible 12 peut comporter une pluralité de ports d'entrée de signal. Plus particulièrement, le circuit électronique sensible 12 peut comporter N rails d'alimentation 30, pouvant être de différents niveaux de tension continue ou de courant électrique continu, chaque rail d'alimentation 30 distribuant une alimentation électrique à un bloc électronique particulier du circuit électronique sensible 12. A titre d'exemple et de manière non limitative, un premier rail d'alimentation 30 peut distribuer une alimentation électrique à un bloc numérique de calcul du circuit électronique sensible 12, un second rail d'alimentation peut distribuer une alimentation électrique à un bloc mémoire du circuit électronique sensible 12, un troisième rail d'alimentation pouvant distribuer une alimentation électrique à un bloc analogique du circuit électronique sensible 12. De manière non limitative, le circuit électronique sensible 12 peut être un microcontrôleur, un circuit de type réseaux logiques programmables, ou encore un circuit intégré propre à une application dénommée communément ASIC.

Selon la figure 1, le système électronique 10 spatial comporte une entrée principale d'alimentation PS configurée pour fournir une alimentation électrique 11 à un dispositif de régulation et stabilisation 14 d'alimentation électrique. Le dispositif de régulation et stabilisation 14 d'alimentation électrique comprend une sortie régulée d'alimentation 32 configurée pour fournir un signal électrique d'alimentation 29 de préférence à au moins un rail d'alimentation 30 du circuit électronique sensible 12. De manière particulière et non limitative, le dispositif de régulation et stabilisation 14 d'alimentation électrique peut comprendre soit un régulateur à faible chute de tension, dénommée couramment régulateur LDO, permettant de réguler la tension de sortie du régulateur même lorsque la tension d'alimentation du régulateur est très proche de la tension de sortie, soit un convertisseur de type continu/continu.

Selon la figure 1, le système électronique spatial 10 comporte une unité électronique de détection de radiations spatiales. L'unité électronique de détection de radiations spatiales peut être par exemple un capteur de radiation détectant directement la quantité de radiations spatiales au niveau du système électronique spatial 10 ou encore plus particulièrement, un dispositif électronique de surveillance du signal électrique d'alimentation 29, le signal électrique d'alimentation pouvant être altéré par un évènement singulier sur le circuit électronique sensible 12 faisant suite à l'exposition du système électronique spatial 10 dans un environnement spatial fortement radiatif. L'altération du signal électrique d'alimentation permet une détection indirecte de la quantité de radiations spatiales au niveau du système électronique spatial 10. A cet effet, le dispositif électronique de surveillance du signal électrique d'alimentation 29 est un dispositif électronique de surveillance du courant électrique 16 instantané délivré par le dispositif de régulation et stabilisation 14 d'alimentation électrique et consommé sur l'au moins un rail d'alimentation 30 du circuit électronique sensible 12 connecté électriquement à la sortie régulée d'alimentation 32. Le dispositif électronique de surveillance du courant électrique 16 peut comprendre différents moyens de capteurs de courant tel que par exemple des capteurs de courant à effet Hall ou des capteurs de mesures différentielles du courant consommé par l'au moins un rail d'alimentation 30.

Selon la figure 1, le système électronique spatial 10 comporte une unité de traitement de signal 34 comprenant des moyens d'analyse de signaux électriques issus de différents capteurs du système électronique spatial 10, et des moyens de contrôle de fonctions de protection 20 du circuit électronique sensible 12 reliés électriquement aux moyens d'analyse de signaux électriques issus de différents capteurs du système électronique 10. Les moyens de contrôle de fonctions de protection 20 du circuit électronique sensible 12 peuvent comprendre par exemple et de manière non limitative, une unité numérique de traitement de type FPGA ou tout autre circuit électronique numérique de type logique permettant de de traiter des informations et de délivrer des signaux de commandes.

Les moyens d'analyse de signaux électriques de l'unité de traitement de signal 34 sont configurés pour comparer une amplitude d'un signal représentative de la quantité de radiations spatiales détectée directement ou indirectement par l'unité électronique de détection de radiations spatiales avec un premier seuil de radiation prédéfini. Plus particulièrement, les moyens d'analyse de signaux électriques de l'unité de traitement de signal 34 comprennent au moins un dispositif de comparaison de courant 18 relié électriquement au dispositif électronique de surveillance du courant électrique 16 instantané et configuré pour comparer l'amplitude du courant mesuré par le dispositif électronique de surveillance du courant électrique 16 instantané avec un seuil de courant prédéfini. Le seuil de courant prédéfini peut être ajusté par les moyens de contrôle de fonctions de protection 20 du circuit électronique sensible 12. De manière particulière le dispositif de comparaison de courant 18 comprend un comparateur analogique dont le temps de traitement est de l'ordre de quelques microsecondes voire une microseconde pouvant comporter un filtre passe-bas en entrée de type filtre RC de constante de temps de l'ordre du dixième de microseconde, voire une microseconde et un filtre passe-bas en sortie de type filtre RC de constante de temps de l'ordre du centième de microseconde, voire un centième de microseconde.

Les moyens de contrôle de fonctions de protection 20 du circuit électronique sensible 12 sont configurés pour commander des dispositifs électroniques de protection du circuit électronique sensible 12 selon notamment le résultat de la comparaison de l'amplitude du signal représentative d'une quantité de radiation détecté par l'unité électronique de détection de radiations spatiales avec le premier seuil de radiation prédéfini. Plus particulièrement, selon la figure 1, les moyens de contrôle de fonctions de protection 20 du circuit électronique sensible 12 sont configurés pour commander des dispositifs électroniques de protection du circuit électronique sensible 12 selon notamment le résultat de la comparaison de l'amplitude du courant mesuré par le dispositif électronique de surveillance du courant électrique 16 instantané avec le seuil de courant prédéfini.

A cet effet, selon la figure 1, le système électronique spatial 10 comporte un premier interrupteur de protection 24 du circuit électronique sensible 12 commandé par les moyens de contrôle de fonctions de protection 20. Le premier interrupteur de protection 24 est agencé entre le rail d'alimentation 30 du circuit électronique sensible 12 de protection et la masse électrique du système électronique spatial 10. Le premier interrupteur de protection 24 est configuré pour être commuté d'un état ouvert, dit encore état bloqué ne laissant pas circuler un courant électrique entre ses bornes, à un état fermé, dit encore état passant laissant circuler un courant électrique entre ses bornes. Cette commutation et la décharge électrique du port d'entrée 300 de signal du circuit électronique sensible 12 conséquente à cette commutation sont réalisées en un temps inférieur à cent microsecondes, de préférence en un temps inférieur à dix ou vingt microsecondes.

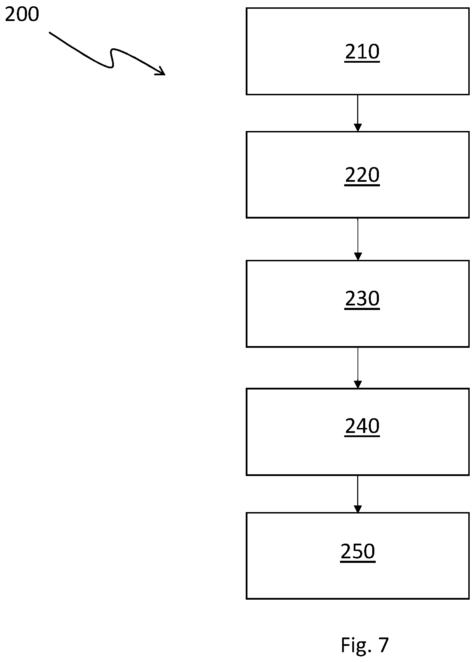

Une telle rapidité de commutation est par exemple intéressante pour la réalisation de tests au sol à base de rayons X, comme décrit ci-dessous en relation avec la figure 7, qui peuvent engendrer un stress thermique important du composant testé avec risque de destruction. En vol comme en cas de test au sol à base d'ion lourds, le stress thermique est moins important, mais une commutation rapide est également utile.

A cet effet, le premier interrupteur de protection 24 est dénommé premier interrupteur brut de protection, par référence à la brutalité électrique de coupure dudit interrupteur. A cet effet, et de manière non limitative, le premier interrupteur de protection 24 peut être un transistor dit transistor de puissance à effet de champs configuré pour pouvoir être commuté par les moyens de contrôle de fonctions de protection 20 du circuit électronique sensible 12 selon un temps de commutation entre un état bloqué à un état passant de moins de cent microsecondes, de préférence moins de dix ou vingt microsecondes. Alternativement, le premier interrupteur de protection 24 peut être implémenté sous la forme de deux transistors bipolaires configurés selon un montage Darlington. En effet, les transistors à effet de champs de type N peuvent être contrôlés facilement car ils nécessitent une tension de grille positive afin de devenir passant. Cependant, les transistors à effet de champs de type N ne tiennent pas de fortes doses cumulées de radiations, ou TID (pour « Total lonizing Dose » dans la littérature anglo-saxonne) et sont ainsi facilement détruits au vu de l'application présentement visée. A contrario, les transistors à effet de champs de type P sont plus résistants vis-à-vis de fortes TID. Cependant, le contrôle des transistors à effet de champs de type P est plus compliqué car nécessitant de générer des tensions de grille négatives afin de devenir passant. Ainsi, l'utilisation de transistors bipolaires montés en Darlington permet d'obtenir un interrupteur de protection qui, d'une part, tient dans la durée malgré de fortes TID et, d'autre part ne présente pas de complexité accrue pour ce qui est du contrôle.

La fermeture du premier interrupteur de protection 24 permet de décharger en moins de cent microsecondes, de préférence moins de dix ou vingt microsecondes, le courant électrique alimentant le circuit électronique sensible 12 de sorte à couper l'alimentation d'un bloc électronique particulier du circuit électronique sensible 12 connecté au rail d'alimentation 30. Pour des raisons d'efficacité de décharges du rail d'alimentation 30 du circuit électronique sensible 12, le premier interrupteur de protection 24 doit être agencé de préférence au plus près de la broche d'entrée du rail d'alimentation 30 du circuit électronique sensible 12. De manière fonctionnelle, le premier interrupteur de protection 24 est configuré pour être commuté dans un état passant lors d'une détection d'une amplitude du niveau du signal représentative de la quantité de radiations spatiales supérieure au seuil de radiation prédéfini, lors d'une surconsommation de courant sur un rail d'alimentation 30 par le dispositif électronique de surveillance du courant électrique 16 instantané associé au dispositif de comparaison de courant 18, ladite surconsommation de courant pouvant être la conséquence d'un évènement singulier causé par des radiations spatiales.

Selon la figure 1, le système électronique spatial 10 comporte un interrupteur d'arrêt 22 du circuit électronique sensible 12 commandé par les moyens de contrôle de fonctions de protection 20. L'interrupteur d'arrêt 22 est agencé de manière parallèle au premier interrupteur de protection 24. L'interrupteur d'arrêt 22 est configuré pour être commuté d'un état ouvert, à un état fermé, en un temps supérieur à cent microsecondes, préférentiellement supérieur à une milliseconde ou de l'ordre de la milliseconde. A cet effet, l'interrupteur d'arrêt 22 est dénommé interrupteur doux de mise en arrêt par opposition à l'interrupteur brut de protection. A cet effet, et de manière non limitative, l'interrupteur d'arrêt 22 peut être un transistor usuel de commutation de type transistor bipolaire configuré pour pouvoir être commuté par les moyens de contrôle de fonctions de protection 20 du circuit électronique sensible 12 selon un temps de commutation entre un état bloqué à un état passant supérieur à cent microsecondes, préférentiellement supérieur à une milliseconde ou de l'ordre d'une milliseconde. La fermeture de l'interrupteur d'arrêt 22 permet de décharger en environ une milliseconde le courant électrique alimentant le circuit électronique sensible 12 de sorte à couper l'alimentation d'un bloc électronique particulier du circuit électronique sensible 12 connecté au rail d'alimentation 30. De manière générale, l'interrupteur d'arrêt 22 est configuré pour être commuté dans un état passant lors d'une demande de mise à l'arrêt du circuit électronique sensible 12 par l'unité de traitement de signal 34 selon le besoin ou non d'activer le circuit électronique sensible 12 au regard du profil de la mission du satellite. Un des avantages de l'agencement de l'interrupteur d'arrêt 22 est de pouvoir rendre hors service le circuit électronique sensible sans engendrer de stress électrique sur le port d'entrée 300 de signal du circuit électronique sensible. A cet effet, l'interrupteur d'arrêt 22 peut ne pas être nécessaire si le port d'entrée 300 de signal protégé par le premier interrupteur de protection 24 du circuit électronique sensible 12 ne présente pas de contre-indications aux commutations brutes, c'est-à-dire aux commutations à la masse électrique effectuées en un temps inférieur à cent microsecondes, de préférence inférieur à dix ou vingt microsecondes.

De manière particulière, l'interrupteur 22 d'arrêt peut être également commuté dans un état passant lors de la détection de radiation spatial moindre pouvant causer un événement singulier de type micro-verrouillage, dénommé couramment selon le terme anglo-saxon micro latch-up. Plus particulièrement, l'interrupteur 22 d'arrêt peut être également commuté dans un état passant lors de la détection d'une surconsommation de courant sur un rail d'alimentation 30 par le dispositif électronique de surveillance du courant électrique 16 instantané associé au dispositif de comparaison de courant 18 pouvant être la conséquence d'un évènement singulier lorsque cette surconsommation est comprise entre un premier seuil de courant prédéfini représentatif par exemple à un évènement singulier de type micro-verrouillage, et un second seuil de courant prédéfini représentatif par exemple à un évènement singulier de type verrouillage, par contre si la surconsommation de courant est supérieure au second seuil de courant prédéfini, le premier interrupteur de protection 24 commute en état passant.

Selon la figure 1, le système électronique spatial 10 comporte également un moyen de coupure 28 de l'alimentation électrique délivrée au rail d'alimentation 30 du circuit électronique sensible 12. A cet effet, selon la figure 1, deux options relatives à la coupure de l'alimentation électrique délivrée au rail d'alimentation 30 sont représentées.

Une première solution d'un moyen de coupure 28 de l'alimentation électrique délivrée au rail d'alimentation 30 du circuit électronique sensible 12 consiste à utiliser un dispositif de régulation et stabilisation 14 comportant une entrée de type marche/ arrêt 36 configurée pour être pilotée par les moyens de contrôle de fonctions de protection 20. Plus particulièrement, selon la première solution, les moyens de contrôle de fonctions de protection 20 sont configurés d'une part pour activer le dispositif de régulation et stabilisation 14 en commandant l'entrée de type marche/arrêt 36 en position de marche de sorte à permettre la délivrance d'une alimentation stabilisée et régulée au rail d'alimentation 30, et d'autre part pour désactiver le dispositif de régulation et stabilisation 14 en commandant l'entrée de type marche/arrêt 36 en position d'arrêt de sorte à couper l'alimentation stabilisée délivrée au rail d'alimentation 30. Cette solution peut être satisfaisante sous condition que le temps de réaction de la coupure de l'alimentation du rail d'alimentation 30 liée à la désactivation du dispositif de régulation et stabilisation 14 soit compatible avec l'effet recherché, notamment de protection du circuit électronique sensible 12.

A cet effet, afin de s'affranchir de toute contraintes de conception du dispositif de régulation et stabilisation 14, une seconde solution d'un moyen de coupure 28 de l'alimentation électrique délivrée au rail d'alimentation 30 du circuit électronique sensible 12 consiste à agencer un interrupteur de coupure 38 commandé par les moyens de contrôle de fonctions de protection 20 et permettant la coupure de l'alimentation électrique délivrée au rail d'alimentation 30. Ledit interrupteur de coupure 38 est agencé en série sur l'alimentation électrique délivrée au rail d'alimentation 30 du circuit électronique sensible 12.

Selon l'invention, le système électronique spatial 10 peut de préférence comprendre pour l'alimentation de chacun des N rails d'alimentations 30 du circuit électronique sensible 12, un premier interrupteur de protection 24 et un interrupteur d'arrêt 22, ainsi qu'un dispositif de régulation et stabilisation 14 d'alimentation électrique associé ou non, selon la solution choisie, à un troisième interrupteur dit interrupteur de coupure 38, tel que décrit selon la figure 1. Le système électronique spatial 10 peut également de préférence comprendre pour l'alimentation de chacun des N rails d'alimentations du circuit électronique sensible 12 ou de manière commune à plusieurs rails d'alimentations 30 un dispositif électronique de surveillance du courant électrique 16 instantané et un dispositif de comparaison de courant 18 tels que décrits à la figure 1.

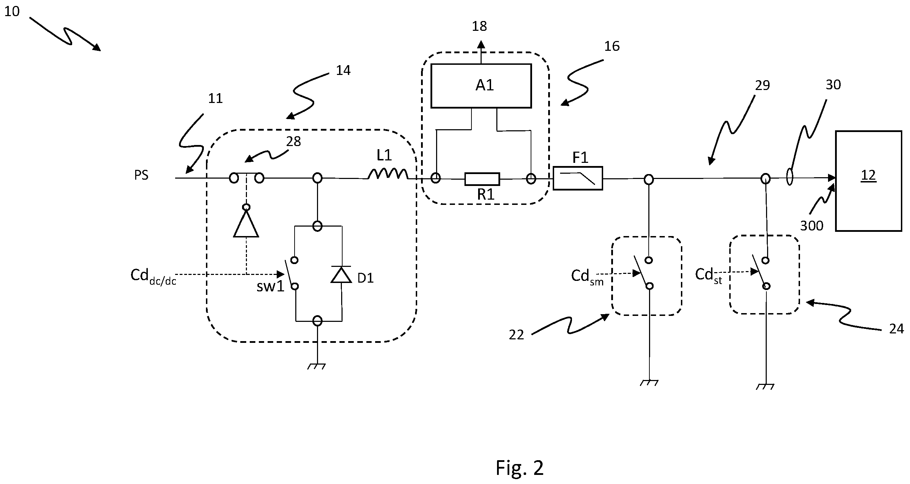

Selon la figure 2, un exemple non limitatif d'un premier mode de réalisation de l'électronique analogique du système électronique spatial 10 de la figure 1 est représenté. A cet effet, l'unité de traitement de signal 34 n'est pas représentée sur la figure 2. A titre d'exemple non limitatif, le dispositif de régulation et stabilisation 14 d'alimentation électrique comprend un convertisseur continu/continu de type abaisseur de tension synchrone usuel comportant donc un interrupteur série avec l'entrée principale d'alimentation PS et un interrupteur de hachage SW1 comportant une diode D1 en parallèle et commandé par un signal de commande de hachage Cd_{dc/dc} depuis l'unité de traitement de signal 34, le signal de commande de hachage Cd_{dc/dc} étant inversé pour piloter l'interrupteur série de l'entrée principale d'alimentation PS. Il est à noter que l'interrupteur série de l'entrée principale d'alimentation PS est un moyen de coupure 28 de l'alimentation électrique délivrée au rail d'alimentation 30 du circuit électronique sensible 12 pouvant donc être commandé depuis l'unité de traitement de signal 34. L'abaisseur de tension comprend de plus un élément inductif L1 permettant de former un filtre de type 'LC' avec la charge.

Selon la figure 2, le dispositif électronique de surveillance du courant électrique 16 comprend un capteur de courant comportant une résistance R1 en série entre la sortie du dispositif de régulation et stabilisation 14 d'alimentation électrique et l'au moins un rail d'alimentation 30 du circuit électronique sensible 12, et un amplificateur différentiel A1 analogique, connecté aux bornes de la résistance R1 série, dont le temps de traitement est de l'ordre de quelques microsecondes, voir une microseconde. De préférence la résistance R1 série est de l'ordre de quelques dizaines de milliohms, voire dix milliohms, l'amplificateur différentiel A1 étant un amplificateur conçu à base de transistors bipolaires, et muni d'un filtre de type RC passe-bas en sortie de constante de temps de l'ordre du dixième de microseconde. Afin de limiter les ondulations dues au hachage de l'abaisseur de tension, un filtre F1 passe bas est agencé en série avec l'alimentation du rail d'alimentation 30 du circuit électronique sensible 12.

Selon la figure 2 et conformément à la figure 1, le premier interrupteur de protection 24, dénommé premier interrupteur brut de protection, est agencé entre le rail d'alimentation 30 du circuit électronique sensible 12 et la masse électrique du système électronique spatial 10. Le premier interrupteur de protection 24 est commandé par l'unité de traitement de signal 34 selon un signal de commande Cdₛₜ en ouverture ou en fermeture selon la détection ou non d'un courant électrique instantané supérieur au seuil de courant prédéfini ; cette surconsommation pouvant être la conséquence d'un évènement singulier. Par exemple et de manière non limitative, afin de supporter la contrainte d'une commutation dans un état fermé dans un temps de l'ordre de dix microsecondes, l'interrupteur brut de protection peut comprendre un transistor à effet de champs de puissance de type canal-P comportant une faible impédance de conduction et une grande transconductance. De manière fonctionnelle, le premier interrupteur de protection 24 est par défaut configuré en mode bloqué, c'est-à-dire ouvert, de sorte à ne pas mettre à la masse électrique le rail d'alimentation 30 du circuit du circuit électronique sensible 12.

Le premier interrupteur de protection 24 peut être commuté en mode passant, c'est-à-dire fermé, lorsqu'un évènement singulier, par exemple de type verrouillage ou SEL, provoque une surconsommation de courant électrique détectée sur le rail d'alimentation 30. A cet effet, l'unité de traitement de signal 34 commande tout d'abord la coupure de l'alimentation électrique délivrée au rail d'alimentation 30 par l'ouverture en à peine quelques microsecondes du moyen de coupure 28 ou interrupteur de coupure du convertisseur continu/continu puis de manière quasi simultanée avec la coupure de l'alimentation du rail 30, la fermeture du premier interrupteur de protection 24 en un temps de l'ordre de dix microsecondes de sorte à décharger de manière ultra rapide l'énergie d'alimentation des blocs électroniques du circuit électronique sensible 12 alimentés par le rail 30 d'alimentation. Cette mise à la masse électrique ultra rapide du rail d'alimentation permet de protéger le circuit électronique sensible 12 d'une destruction pouvant, par exemple et de manière non limitative, être causée par un effet thermique (ou une électromigration) conséquent à un évènement singulier provoquant une surconsommation excessive du courant électrique détecté par le dispositif électronique de surveillance du courant électrique 16. Cette mise à la masse ultra rapide peut engendrer un stress électrique sur le circuit électronique sensible 12, de sorte qu'un nombre limité de commutation à la masse du premier interrupteur de protection 24 est à prévoir dans ce cas de stress afin de pouvoir garantir une durée de vie du circuit électronique sensible au regard des exigences spatiales.

A cet effet et selon la figure 2, l'interrupteur d'arrêt 22, dénommé interrupteur doux de mise en arrêt, est agencé électriquement en parallèle avec le premier interrupteur de protection 24. L'interrupteur d'arrêt 22 est commandé par l'unité de traitement de signal 34 selon un signal de commande Cdₛₘ en ouverture ou en fermeture selon le besoin ou non de couper le circuit électronique sensible 12. Par exemple et de manière non limitative, la coupure du circuit électronique sensible 12 peut être commandée par l'unité de traitement de signal 34 lorsque celui-ci n'a pas besoin d'être opérationnel. Une commutation de l'ordre de la milliseconde après la coupure de l'alimentation électrique délivrée au rail d'alimentation 30 par l'ouverture du moyen de coupure 28 du convertisseur continu/continu ne génère aucun stress électrique sur le circuit électronique sensible 12 et peut donc être répétée de nombreuses fois. A titre d'exemple non limitatif, l'interrupteur d'arrêt 22 peut comprendre un transistor bipolaire de type NPN, pilotable de manière classique et permettant la conduction de courant faible en comparaison avec le transistor MOS de puissance. De façon particulière, la mise à la masse électrique du rail d'alimentation 30 par l'interrupteur d'arrêt 22 peut être commandée par les moyens de contrôle de fonctions de protection 20 afin de protéger le circuit électronique sensible 12 d'une dégradation consécutive à un évènement singulier engendrant une surconsommation de courant électrique moindre mesurée par le dispositif électronique de surveillance du courant électrique 16.

De manière générale, il est à noter que le convertisseur continu/continu abaisseur de tension de la figure 2 peut également être un convertisseur continu/continu de type élévateur de tension, ce choix dépendant de la tension devant être délivré au rail d'alimentation 30 du circuit électronique sensible 12.

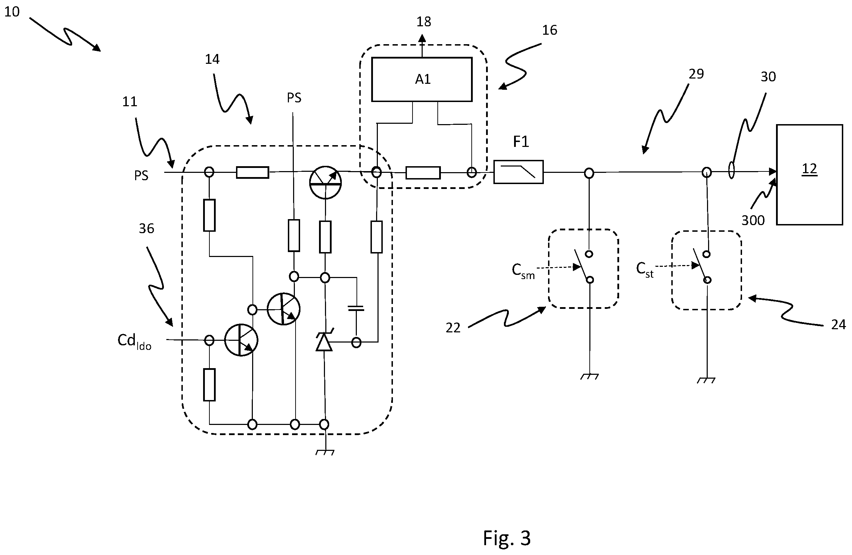

Selon la figure 3, un exemple non limitatif d'un second mode de réalisation de l'électronique analogique du système électronique spatial 10 de la figure 1 est représenté. Le second mode de réalisation de la figure 3 diffère uniquement du premier mode de réalisation représenté à la figure 2 en ce que le dispositif de régulation et stabilisation 14 d'alimentation électrique est réalisé par un régulateur à faible chute de tension ou LDO. Le dispositif de régulation et stabilisation 14 de ce second mode de réalisation comprend une structure analogique à multiple transistors bipolaires et également une entrée de type marche/arrêt 36 pilotée par un signal de commande marche/arrêt Cd_{ldo} provenant des moyens de contrôle de fonctions de protection 20 du circuit électronique sensible 12 de l'unité de traitement de signal 34.

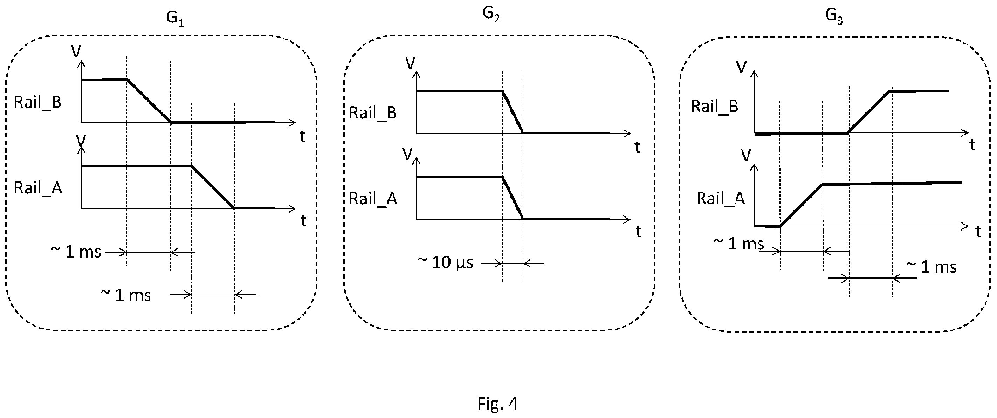

Selon la figure 4, deux groupes G1, G2 de deux chronogrammes relatifs aux mises à la masse électrique de deux ports d'entrée de signal du circuit électronique sensible sont représentés. Plus particulièrement, une séquence de mise à la masse électrique d'un premier rail d'alimentation Rail_A du circuit électronique sensible 12, et une commande de mise à la masse électrique d'un second rail d'alimentation Rail_B du circuit électronique sensible 12, sont représentés. Selon la figure 4, le premier groupe G1 représente le séquencement de la mise à la masse électrique du premier rail d'alimentation Rail_A et du second rail d'alimentation Rail_B lors de la commande en fermeture d'un premier interrupteur d'arrêt 22 agencé entre le premier Rail_A d'alimentation 30 du circuit électronique sensible 12 et la masse électrique du système électronique spatial 10, et lors de la commande de fermeture d'un second interrupteur d'arrêt, distinct du premier interrupteur d'arrêt 22 agencé entre le second Rail_B d'alimentation 30 du circuit électronique sensible 12 et la masse électrique du système électronique spatial 10. Selon le premier groupe G1 de chronogrammes, la fermeture du premier interrupteur d'arrêt 22 relatif au premier Rail_A d'alimentation 30 est effectué de manière séquentielle après la fermeture du second interrupteur d'arrêt 22 relatif au second Rail_B d'alimentation 30. Selon le premier groupe G1 de chronogrammes, le temps de commutation de l'état ouvert à l'état fermé de chacun des deux interrupteurs d'arrêt 22 est de l'ordre d'une milliseconde. Ce séquencement permet une coupure de deux rails Rail_A, Rail_B d'alimentation sans provoquer de stress électrique au circuit électronique sensible 12. De manière générale, une mise à la masse électrique douce, c'est-à-dire une commutation depuis l'état ouvert jusqu'à l'état fermé des interrupteurs d'arrêt 22 de l'ordre de la milliseconde pour chacun des rails d'alimentation du circuit électronique sensible 12, associée si nécessaire à un séquencement de mise à la masse électrique des rails d'alimentation selon leur niveau initial de tension, permet de couper l'ensemble des alimentations d'un circuit électronique sensible sans provoquer des stress électriques pouvant endommager les structures internes du circuit électronique sensible 12. Selon l'invention, une mise à la masse électrique douce, permet de couper l'ensemble des alimentations d'un circuit électronique sensible 12 de manière à éviter la dégradation relativement à un évènement singulier produisant une faible surconsommation de courant du circuit électronique sensible 12.

Selon la figure 4, le second groupe G2 représente une séquence de fermeture d'un premier interrupteur de protection 24 agencé électriquement en parallèle avec le premier interrupteur d'arrêt 22, et de fermeture d'un second interrupteur de protection, distinct du premier interrupteur de protection 24 agencé électriquement en parallèle avec le second interrupteur d'arrêt. Selon le second groupe G2 de chronogrammes, la fermeture du premier interrupteur de protection 24 relatif au premier Rail_A d'alimentation 30 est effectuée de manière simultanée avec la fermeture du second interrupteur de protection relatif au second Rail_B d'alimentation 30. Selon le second groupe G2 de chronogrammes, le temps de commutation de l'état ouvert à l'état fermé de chacun des deux interrupteurs de protection 24 est de l'ordre de dix microsecondes. Cette fermeture simultanée des deux interrupteurs de protection 24 selon un temps de commutation de l'état ouvert à la fin de la décharge de l'ordre de dix microsecondes permet une protection immédiate du circuit électronique sensible 12 de sorte à éviter une dégradation du circuit électronique sensible 12 faisant suite à un évènement singulier provoquant une forte surconsommation du courant électrique du circuit électronique sensible 12. De manière générale, une coupure brute, c'est-à-dire une coupure de l'ordre de la dizaine de microsecondes de chacun des rails d'alimentation 30 du circuit électronique sensible 12, associée à une mise à la masse quasi simultanée des rails d'alimentation, permet de couper l'ensemble des alimentations d'un circuit électronique sensible 12 de manière à éviter la destruction relativement à un évènement singulier. Selon l'invention, le nombre de commutations des interrupteurs de protection 24 à la masse électrique du système électronique spatial 10 doit être limité afin que l'accumulation de stress électrique induit sur le circuit électronique sensible à chaque commutation ne puisse pas engendrer une réduction de la durée de vie du circuit électronique sensible 12 au regard des exigences spatiales. Il est à noter qu'une mise à la masse quasi simultanée, c'est à dire de manière séquentielle peut être envisagée, si la mise à la masse de l'ensemble des ports d'entrée de signal, en l'espèce, l'ensemble des rails d'alimentations, sont commutés en un temps cumulé de l'ordre de la dizaine de microsecondes.

Selon la figure 4, un troisième groupe G3 de chronogramme représentatif du rétablissement de l'alimentation du premier rail d'alimentation Rail_A et du second rail d'alimentation Rail_B du circuit électronique sensible 12 est représenté. A cet effet, l'ouverture des interrupteurs de protection 24 par l'unité de traitement de signal 34 est suivi par une fermeture séquentielle des moyens de coupure 28, 38 de l'alimentation, c'est-à-dire par les interrupteurs de coupure 38 de chacun des rails d'alimentation Rail_A, Rail_B. Cette fonctionnalité permet un réarmement automatique du système électronique spatial 10 après la commutation en fermeture des interrupteurs de protection 24 du circuit électronique sensible 10, permettant à nouveau le fonctionnement optimal du système électronique spatial 10. De manière équivalente, l'ouverture et la fermeture des interrupteurs d'arrêt 22 peuvent être effectuées de manière similaire à celle décrite pour les interrupteurs de protection 24.

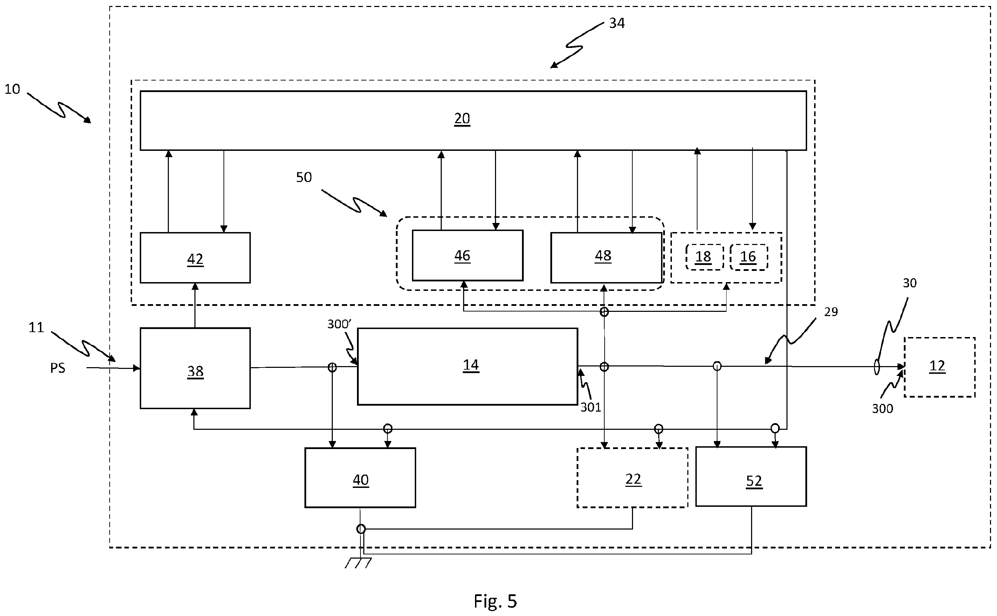

Selon la figure 5, un second mode de réalisation du système électronique spatial 10 est représenté. Ce second mode de réalisation permet de protéger un autre circuit électronique sensible du système électronique spatial contre les radiations spatiales pouvant engendrer des évènements singuliers sur cet autre circuit électronique sensible. Plus précisément, ce second mode de réalisation permet de protéger l'autre circuit électronique sensible du système électronique spatial comportant au moins un port d'entrée 300 de signal et/ou un port de sortie de signal, l'autre circuit électronique sensible pouvant être endommagé par un évènement singulier.

En effet, il n'est pas exclu par exemple que le dispositif de régulation et stabilisation 14 d'alimentation électrique de la figure 5 soit un circuit électronique également sensible aux radiations spatiales provoquant des évènements singuliers, que ce soit du type verrouillage dit SEL pouvant causer la dégradation ou la destruction du dispositif de régulation et stabilisation 14 d'alimentation électrique par effet thermique. Dans l'hypothèse d'un autre composant électronique sensible comportant un port de sortie 301 de signal, comme par exemple selon la figure 5 un dispositif de régulation et stabilisation 14 d'alimentation électrique comportant notamment une partie numérique de configuration de la tension ou du courant délivré par le port de sortie de signal, un évènement singulier de perturbation dit SEU (Single event upset) peut causer l'altération d'un registre de configuration du signal de sortie pouvant provoquer l'endommagement du composant alimenté électriquement par le dispositif de régulation et stabilisation 14, en l'occurrence, selon la figure 5, ledit circuit électronique sensible12 de la figure 1.

Selon la figure 5, bien que représenté, le circuit électronique sensible12 et son interrupteur d'arrêt 22, ainsi que le dispositif électronique de surveillance du courant électrique 16 instantané et le dispositif de comparaison de courant 18 permettant de superviser le courant électrique consommé par le circuit électronique sensible12 ne font pas partie des éléments électroniques permettant la protection du dispositif de régulation et stabilisation 14 d'alimentation électrique contre les évènements singuliers. Selon la figure 5, et de manière similaire à la figure 1, le système électronique spatial 10 comporte l'unité de traitement de signal 34 comprenant des moyens d'analyse de signaux électriques issus de différents capteurs du système électronique spatial 10, et des moyens de contrôle de fonctions de protection 20 reliés électriquement aux moyens d'analyse de signaux électriques issus de différents capteurs du système électronique spatial 10.

Selon la figure 5 et de manière similaire à la protection du circuit électronique sensible 12, l'unité électronique de détection de radiations spatiales comporte un autre dispositif de surveillance du courant électrique 42 agencé pour permettre la surveillance du courant consommé par le port d'entrée 300' de signal, i.e. l'entrée d'alimentation électrique, du dispositif de régulation et stabilisation 14 d'alimentation électrique. Les moyens de contrôle de fonctions de protection 20 de l'unité de traitement de signal 34 sont configurés pour commuter depuis un état ouvert à un état passant un second interrupteur de protection 40 du même type que le premier interrupteur de protection 24, le second interrupteur de protection 40 étant agencé entre le port d'entrée 300' de signal du dispositif de régulation et stabilisation 14 d'alimentation électrique et la masse électrique du système électronique spatial 10. Selon la figure 5, l'unité électronique de détection de radiations spatiales comporte un autre dispositif électronique de surveillance du signal électrique d'alimentation 29. Selon la figure 5, l'autre dispositif électronique de surveillance du signal électrique d'alimentation 29 est un dispositif électronique de surveillance de tension 50 configuré pour aussi bien détecter les surtensions que les sous-tensions sur la sortie régulée d'alimentation 32 du dispositif de régulation et stabilisation 14 d'alimentation électrique. De manière avantageuse, et afin d'optimiser le temps de réaction du dispositif de surveillance de tension 50, ce dernier peut comporter, par exemple et de manière non limitative, un amplificateur opérationnel analogique de tension dont le temps de traitement est de l'ordre d'une microseconde permettant la capture et la mesure de la tension d'alimentation de sortie régulée 32, i.e. telle que présente sur le port de sortie 301 de signal, du dispositif de régulation et stabilisation 14 d'alimentation électrique. L'amplificateur analogique de tension est configuré pour délivrer un signal image de la tension d'alimentation de sortie régulée 32 à un premier comparateur analogique 46 dont le temps de traitement est de l'ordre d'une microseconde et configuré pour comparer la tension mesurée à un premier seuil minimum de tension en dessous duquel l'unité de traitement de signal 34 estime qu'il s'agit d'une sous-tension pouvant être la conséquence d'un évènement singulier, notamment de type évènement de perturbation ou SEU. De manière comparable, l'amplificateur analogique de tension est configuré pour délivrer le signal image de la tension d'alimentation de sortie régulée 32 à un second comparateur analogique 48 dont le temps de traitement est de l'ordre d'une microseconde et configuré pour comparer la tension mesurée à un second seuil maximum de tension au-dessus duquel l'unité de traitement de signal 34 estime qu'il s'agit d'une surtension pouvant être la conséquence d'un évènement singulier, notamment de type évènement de perturbation ou SEU.

A cet effet, selon la figure 5, le système électronique spatial 10 comporte un troisième interrupteur de protection 52, d'un type similaire au premier interrupteur de protection 24, commandé par les moyens de contrôle de fonctions de protection 20 de l'unité de traitement de signal 34. Le troisième interrupteur de protection 52 est agencé entre le port de sortie 301 de signal du dispositif de régulation et stabilisation 14 d'alimentation électrique et la masse électrique du système, c'est-à-dire entre la tension d'alimentation de sortie régulée 32 du dispositif de régulation et stabilisation 14 d'alimentation électrique et la masse électrique du système électronique spatial 10. Le troisième interrupteur de protection 52 est configuré pour être commuté simultanément avec le second interrupteur de protection 40 par les moyens de contrôle de fonctions de protection 20 dans un étant passant, c'est-à-dire dans un état fermé, lors de la détection d'une surtension, et aussi lors de la détection d'une sous tension par le dispositif de surveillance de tension 50.

En effet, un dispositif de régulation et stabilisation 14 d'alimentation électrique comprend couramment différents étages qui peuvent se retrouver isolés électriquement entre eux lorsque le dispositif en question n'est plus alimenté. C'est par exemple le cas pour un convertisseur de type continu/continu qui fonctionne par transfert de charges électriques entre l'étage d'entrée et l'étage de sortie au rythme de la fréquence de hachage. Suivant de telles architectures électroniques, une mise à la masse uniquement du port de sortie permet d'écouler les charges accumulées dans l'étage de sortie du dispositif considéré, mais pas les charges accumulées dans son étage d'entrée. A contrario, la mise à la masse du port d'entrée de signal permet d'écouler de telles charges accumulées dans l'étage d'entrée. Ainsi, la mise à la masse à la fois du port d'entrée de signal et du port de sortie du signal permet une meilleure protection du dispositif de régulation et stabilisation 14.

Selon le scénario pour lequel le système électronique spatial 10 comprend un dispositif de régulation et stabilisation 14 d'alimentation électrique sensible aux radiations spatiales provoquant des évènements singuliers, et également le circuit électronique sensible 12 alimenté électriquement par le dit dispositif de régulation et stabilisation 14 d'alimentation électrique sensible, de préférence, le système électronique spatial 10 comprend le troisième interrupteur de protection 52 agencé au plus près de la sortie régulée 32 du dispositif de régulation et stabilisation 14 d'alimentation électrique et le premier interrupteur de protection 24 agencé au plus près du rail d'alimentation 30 du circuit électronique sensible 12.

De manière alternative, selon le même scénario, le système électronique spatial 10 peut comprendre un unique interrupteur de protection en lieu et place du premier interrupteur de protection 24 et du troisième interrupteur de protection 52. Le dit unique interrupteur de protection peut être agencé de préférence au plus proche du rail d'alimentation 30 du circuit électronique sensible 12. De manière similaire à la figure 1, le second mode de réalisation du système électronique spatial 10 comporte un interrupteur de coupure 38 agencé en amont du dispositif de régulation et stabilisation 14, c'est-à-dire en série entre l'entrée principale d'alimentation PS et dispositif de régulation et stabilisation 14 de l'alimentation électrique. De la même manière que pour le mode de réalisation de la figure 1, l'interrupteur de coupure 38 est commandé en ouverture en quelques microsecondes préalablement à la fermeture du ou des interrupteurs de protection, les dits interrupteurs de protection étant commutés à l'état fermé en un temps de l'ordre de dix microsecondes.

De manière générale et selon la figure 1 et la figure 5, le système électronique spatial 10 peut comprendre donc au moins un premier interrupteur de protection 24, 40 configuré pour une mise à la masse électrique du port d'entrée de signal d'un circuit électronique sensible aux radiations spatiales, ledit premier interrupteur de protection 24, 40 étant commandé en fermeture lors d'une détection d'une amplitude du signal représentative de la quantité de radiations spatiales supérieure à un seuil de radiations prédéfini. Le système électronique spatial 10 peut comprendre également au moins un interrupteur d'arrêt 22 agencé électriquement en parallèle avec l'au moins un interrupteur de protection 24, 40, l'au moins un interrupteur d'arrêt 22 étant configuré pour mettre hors de fonctionnement le circuit électronique sensible d'une manière dite douce, c'est à dire selon une commutation à l'état fermé ne générant pas de stress électrique au circuit électronique sensible. De manière générale et selon la figure 5, le système électronique spatial 10 peut comprendre également au moins un second interrupteur de protection 52 configuré pour une mise à la masse électrique du port de sortie de signal d'un circuit électronique sensible aux radiations spatiales, ledit second interrupteur de protection 52 étant commandé en fermeture lors d'une détection d'une amplitude du signal représentative de la quantité de radiations spatiales supérieure au seuil de radiations prédéfini.

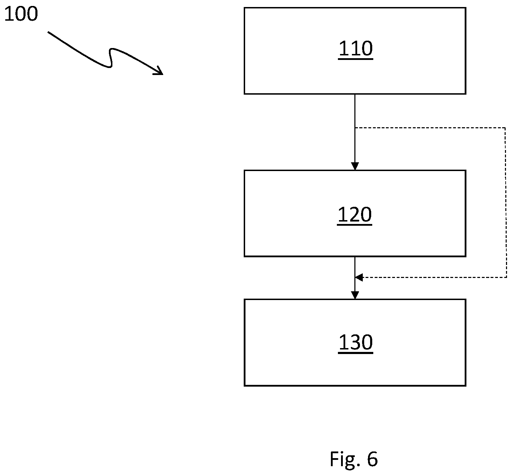

Selon la figure 6, une méthode de protection 100 d'un circuit électronique sensible 12 aux radiations spatiales du système électronique spatial 10 décrit aux figures 1 à 5, est illustré. La méthode de protection 100 comprend tout d'abord une étape de détection 110 d'une amplitude du signal représentative de la quantité de radiations spatiales supérieure à un seuil de radiations prédéfini, telle que par exemple la détection d'une amplitude du signal électrique d'alimentation 29 d'au moins une alimentation électrique 11 d'une pluralité d'alimentations électriques du circuit électronique sensible en dehors d'au moins une plage de valeurs d'amplitudes prédéfinies. Plus particulièrement, l'étape de détection 110 d'une amplitude du signal électrique d'alimentation 29 peut être une étape de détection d'une surconsommation de courant électrique de l'entrée d'alimentation électrique d'au moins un dispositif de régulation et stabilisation 14 d'alimentation électrique d'une pluralité de dispositifs de régulation et stabilisation 14 d'alimentation électrique.

Suite à l'étape de détection 110, la méthode comprend une étape de commutation 130 à la masse électrique d'un ou plusieurs interrupteurs de protection 24 du système électronique spatial. Dans certains modes de réalisation, chacun des interrupteurs de protection 24 du système électronique spatial est commuté à la masse électrique. Lorsque plusieurs interrupteurs de protection 24 sont commutés à la masse, la commutation peut se faire de manière simultanée ou quasi simultanée. Par ailleurs, dans certains modes de réalisation un ou plusieurs interrupteurs d'arrêt 22 du système électronique spatial sont également commutés à la masse électrique lors de l'étape 130. Dans certains modes de réalisation, chacun des interrupteurs d'arrêt 22 du système électronique spatial est commuté à la masse électrique lors de l'étape 130. Lorsque plusieurs interrupteurs d'arrêt 22 sont commutés à la masse, la commutation peut se faire de manière simultanée ou quasi simultanée. De manière additionnelle, suite à l'étape de détection 110, la méthode de protection 100 peut comprendre une étape de coupure 120 des alimentations électriques 11 du circuit électronique sensible.

Selon la figure 7, une méthode 200 de test garantissant une durée de vie prédéfinie du système électronique spatial 10 est représentée. Un des avantages principaux de la méthode de l'invention est de pouvoir tester au sol la robustesse du système électronique 10 aux radiations spatiales dans sa configuration hardware prévue pour être embarquée à bord d'un satellite. Plus particulièrement, le test est d'autant plus représentatif des conditions d'un mode opérationnel du système électronique spatial 10 embarqué dans un satellite en orbite terrestre, que le test est effectué selon une méthode pour laquelle le composant sensible 12 n'est ni dépourvu de son boîtier de protection, ni aminci dans le cas d'un composant de type puce retournée communément dénommée selon le terme anglo-saxon 'flip chip'.

Selon l'invention, une première étape consiste en un envoi d'ions lourds pénétrants ou de rayonnement pénétrant 210 sur le circuit électronique sensible 12. On appelle un envoi d'ions lourds pénétrants, un envoi selon lequel les ions lourds s'introduisent dans les couches de silicium d'une puce électronique selon une profondeur de quelques centaines de µm, typiquement 500µm. Un exemple d'installation permettant de générer ces ions lourds est le GANIL qui permet une pénétration d'environ 600µm dans le Si à 60 MeV.cm2/mg en ion Xe. De façon comparable à une exposition du circuit électronique sensible 12 aux ions lourds, l'envoi de certains rayonnements peut déclencher des évènements singuliers entrainant la dégradation voire la destruction d'un circuit électronique sensible 12 en y provoquant des évènements singuliers. Il s'agit notamment de rayonnement X. Ce type de rayonnement peut être généré dans un synchrotron, comme par exemple le synchrotron européen ESRF. Le niveau de rayonnement est choisi pour être juste suffisamment puissant pour entrainer des évènements singuliers représentatifs de l'environnement spatial et limiter les effets dus à la surexposition. Une étape de la méthode 200 de test peut consister à procéder à l'acquisition 220 du nombre de commutation à la masse électrique des interrupteurs de protection 24 durant la séquence d'envoi d'ions lourds pénétrants ou de rayonnement pénétrant. Plus particulièrement, cette étape 210 consiste à cibler différentes zones géographiques du circuit électronique sensible 12 de sorte à contraindre différents blocs électroniques du circuit électronique sensible 12. A cet effet, selon l'invention, chaque envoi de l'étape d'envoi d'ions lourds pénétrants ou de rayonnement pénétrant 210 induit une commutation d'un ou plusieurs interrupteurs de protection 24, chacun des interrupteurs pouvant être recommutés automatiquement en un état ouvert entre chaque envoi de la séquence 210.

Afin de garantir une durée de vie prédéfinie du système électronique spatial 10 embarqué à bord d'un satellite en orbite terrestre, par exemple et de manière non limitative, pour une durée de vie garantie de quinze ans, il conviendra de déclencher des commutations à la masse électrique des interrupteurs de protection 24 autant de fois que ces commutations pourraient se déclencher dans l'environnement spatial radiatif. A cet effet, la méthode 200 de test peut comprendre si nécessaire, une étape faisant suite à l'étape d'envoi ou de bombardement, de commutation 230 répétée et complémentaire aux commutations des interrupteurs de protection durant l'étape d'envoi ou de bombardement, jusqu'à un nombre prédéfini de commutations à la masse électrique représentatif d'un nombre estimatif de commutations à la masse électrique des interrupteurs de protection 24 pouvant se déclencher durant la durée de vie prédéfinie du système électronique spatial 10 dans son environnement spatial si le nombre acquis à l'étape d'acquisition 220 est insuffisant. Le nombre prédéfini de commutations est généralement issu de statistiques estimées par modélisation et retour d'expérience de satellites évoluant à différentes altitudes en orbite terrestre, le niveau de radiations spatiales pouvant dépendre de l'altitude en orbite du satellite embarquant un système électronique spatial 10. Par exemple et de manière non limitative, le nombre de commutation peut être de l'ordre de quelques centaines sur une durée de quinze ans.

Toutefois, les étapes 220 et 230 sont optionnelles. En effet, suivant la nature des ions lourds pénétrants ou du rayonnement pénétrant mis en œuvre lors de l'étape 210, le ciblage de zones géographiques du circuit électronique sensible 12 est plus ou moins précis. Par exemple, dans le cas d'un test avec rayons X, le rayonnement pénétrant est moins localisé qu'avec des ions lourds. Ainsi, de part ce caractère diffus, le rayonnement pénétrant peut affecter différentes parties du circuit électronique sensible 12 ou du reste du système 10 conduisant à n'avoir qu'un seul déclenchement pour plusieurs évènements singuliers. Ainsi, avec un rayonnement représentatif de l'environnement spatial durant la durée de vie estimée du circuit électronique sensible 12, le nombre de commutations de l'état bloqué à l'état passant d'un interrupteur de protection 24 donné peut être inférieur à ce qui est attendu en vol durant la durée de vie estimée du circuit en question. Dans ce cas, la mise en œuvre des étapes 220 et 230 présente un intérêt. A contrario, avec un rayonnement pouvant être focalisé précisément sur une zone géographique donnée du circuit électronique sensible 12, comme par exemple avec des ions lourds, on peut espérer que le nombre de commutations de l'état bloqué à l'état passant d'un interrupteur de protection 24 donné est représentatif de ce qui est attendu en vol durant la durée de vie estimée du composant. Dans de tels cas, la mise en œuvre des étapes 220 et 230 n'est pas utile.

La dernière étape de la méthode 200 de test comprend une étape de tests 250 fonctionnels du système électronique spatial 10 pendant une durée prédéterminée et sous contrainte thermique représentatives d'un vieillissement accéléré équivalent à la durée de vie prédéfinie du système électronique spatial 10 embarqué à bord d'un satellite en orbite terrestre. A titre d'exemple non limitatif, des tests fonctionnels répétés pendant douze mois sous contrainte thermique de quatre-vingt-quinze degrés au niveau du silicium, peuvent être représentatifs du fonctionnement du système électronique spatial 10 pendant huit ans avec une température de jonction du circuit électronique sensible 12 d'environ soixante degrés Celsius avec une marge d'environ dix pourcents.

En cas de défaillance fonctionnelle du système électronique spatial 10 testé, alors le système électronique spatial 10 ne pourrait être embarqué dans un satellite.

De manière optionnelle, la méthode 200 de test peut comprendre suite à l'étape 230, une étape de détermination 240 de l'état des structures du circuit électronique sensible 12 par imagerie du circuit électronique sensible 12 suite à l'étape d'envoi ou de bombardement 210. Cette étape permet de vérifier l'efficacité des interrupteurs de protection 24 de sorte que si un défaut de structure d'un bloc électronique du circuit électronique sensible 12 était identifié par imagerie, alors le système électronique spatial 10 ne pourrait être embarqué dans un satellite.

De manière non limitative, l'observation par imagerie peut consister en une observation de type optique visible afin de chercher à identifier/localiser d'importantes dégradations dues aux évènements singuliers qui seraient directement visibles sur la surface externe du circuit électronique sensible 12. L'observation par imagerie peut également consister en une observation de type optique infrarouge afin de chercher à identifier/localiser des points chauds absents sur un composant témoin et par ce biais les zones concernées par un évènement singulier et également chercher à identifier/ localiser des dégradations sur les métallisations de plus haut et de plus bas niveau en profitant du fait que le silicium est transparent aux infrarouges.

L'observation par imagerie peut également consister en une observation de type photonique afin de chercher à identifier/localiser, après un masquage permettant de limiter la zone de recherche en complément ou remplacement de l'imagerie infrarouge, les zones concernées par un évènement singulier pendant que celui-ci est activé, sans la problématique de pénétration des infrarouges limitée aux éléments non-transparents à savoir les métallisations et sans la problématique de limite de résolution due à la longueur d'onde des méthodes optiques. Également, l'observation par imagerie peut également consister en une observation de type électronique à balayage afin d'effectuer une imagerie couche par couche de la puce avec déconstruction progressive par polissage plasma et chercher à contrôler l'absence de défauts dans les zones préalablement identifiées pendant les étapes précédentes. La méthode 200 de test peut comprendre suite à l'étape 230 ou 240 une étape 250 de tests fonctionnels.

## Revendications

1. Système électronique spatial (10) comportant :
- un circuit électronique sensible (14) aux radiations spatiales comprenant au moins un port d'entrée (300') de signal et au moins un port de sortie (301) de signal, le circuit électronique (14) sensible étant du type dispositif de régulation et stabilisation d'alimentation électrique;
- une unité de traitement de signal (34) ;
- une unité électronique de détection de radiations spatiales électriquement connectée à l'unité de traitement de signal (34);
- au moins un interrupteur de protection (40) connecté électriquement entre la masse électrique du système électronique spatial (10) et au moins un des ports d'entrée (300') du circuit électronique sensible (14), et commandé par l'unité de traitement de signal (34); et
- au moins un interrupteur de protection (52, 24) connecté électriquement entre la masse électrique du système électronique spatial (10) et au moins un des ports de sortie de signal du circuit électronique sensible (14), et commandé par l'unité de traitement de signal (34),
l'unité de traitement de signal (34) étant configurée pour commuter lesdits au moins un interrupteur de protection (40, 52, 24) à la masse électrique lors de la détection d'une amplitude d'un signal représentative de la quantité de radiations spatiales supérieure à un seuil de radiation prédéfini.

2. Système (10) selon l'une quelconque des revendications précédentes comprenant au moins un interrupteur d'arrêt (22) agencé électriquement en parallèle avec l'au moins un interrupteur de protection (40) connecté électriquement entre la masse électrique du système électronique spatial (10) et au moins un des ports d'entrée de signal du circuit électronique sensible (14), l'unité de traitement de signal (34) étant configurée pour commuter l'interrupteur d'arrêt (22) à la masse électrique lors d'une mise hors service du circuit électronique sensible (14).

3. Système (10) selon la revendication précédente pour lequel l'au moins un interrupteur d'arrêt (22) comporte un transistor bipolaire configuré pour être commuté d'un état électrique bloqué à un état électrique passant en un temps supérieur à cent microsecondes, préférentiellement supérieur à une milliseconde.

4. Système (10) selon l'une quelconque des revendications précédentes pour lequel l'unité électronique de détection de radiations spatiales comprend un dispositif électronique de surveillance du courant électrique (42) du port d'entrée de signal.

5. Système (10) selon l'une quelconque des revendications précédentes pour lequel l'unité électronique de détection de radiations spatiales comprend un dispositif électronique de surveillance de tension électrique (50) du port de sortie de signal.

6. Système (10) selon l'une quelconque des revendications précédentes pour lequel au moins un interrupteur de protection (40, 52) comporte un transistor à effet de champs ou un montage en Darlington de deux transistors bipolaires.

7. Système (10) selon l'une quelconque des revendications précédentes dans lequel au moins un interrupteur de protection (40, 52) est configuré pour être commuté d'un état électrique bloqué à un état électrique passant en un temps de moins de cent microsecondes, de préférence moins de dix microsecondes.

8. Système (10) selon l'une quelconque des revendications précédentes pour lequel au moins un port d'entrée de signal est un rail d'alimentation électrique (30) du circuit électronique sensible (14).

9. Méthode de protection (100) du circuit électronique sensible (14) du système électronique spatial (10) de l'une quelconque des revendications précédentes, la méthode de protection (100) comprenant les étapes de :
- détection (110) d'une amplitude du signal représentative de la quantité de radiations spatiales supérieure à un seuil de radiation prédéfini ;
- commutation (130) à la masse électrique desdits au moins un interrupteur de protection (40, 52).

10. Méthode de protection (100) selon la revendication 9, le système électronique spatial (10) comportant au moins deux interrupteurs de protection (40, 52), l'étape de commutation (130) comprenant la commutation (130) à la masse électrique de chacun des au moins deux interrupteurs de protection (40, 52) de manière simultanée.

11. Méthode (200) de test garantissant une durée de vie prédéfinie du système électronique spatial (10) de l'une quelconque des revendications 1 à 8, la méthode (200) de test comportant les étapes au sol de :
- envoi d'ions lourds pénétrants (210) ou de rayonnement pénétrant apte à créer du latch-up sur le circuit électronique sensible (14) ; et
- tests (250) fonctionnels du système électronique spatial (10) suite à l'étape d'envoi (210), pendant une durée prédéterminée et sous contrainte thermique représentatives d'un vieillissement accéléré équivalent à la durée de vie prédéfinie du système électronique spatial (10) embarqué à bord d'un satellite en orbite terrestre.

12. Méthode (200) selon la revendication 11 comprenant de plus les étapes au sol de :
- acquisition (220) du nombre de commutation de l'état bloqué à l'état passant d'au moins un interrupteur de protection (40, 52) durant l'étape d'envoi (210)
- comparaison du nombre de commutation acquis avec un nombre prédéfini Np de commutations à la masse électrique représentatif d'un nombre estimatif de commutations à la masse électrique pouvant se déclencher durant la durée de vie prédéfinie du système électronique dans son environnement spatial ;
- si le nombre de commutations acquis est inférieur au nombre prédéfini Np de commutations, commutation (230) répétée et complémentaire aux commutations de l'au moins un interrupteur de protection durant l'étape d'envoi ou de bombardement (210), jusqu'à un nombre prédéfini de commutations à la masse électrique représentatif d'un nombre estimatif de commutations à la masse électrique pouvant se déclencher durant la durée de vie prédéfinie du système électronique dans son environnement spatial.

13. Méthode (200) selon la revendication 11 ou 12 comprenant de plus une étape de :
- détermination (240) de l'état des structures du circuit électronique sensible (14) par imagerie du circuit électronique sensible (14) suite à l'étape d'envoi (210).

## Patentansprüche

1. Raumelektroniksystem (10), umfassend:
- eine räumlich strahlungsempfindliche elektronische Schaltung (14), die mindestens einen Signaleingangsanschluss (300') und mindestens einen Signalausgangsanschluss (301) umfasst, wobei die empfindliche elektronische Schaltung (14) vom Typ Vorrichtung zur Regelung und Stabilisierung der Stromversorgung ist;
- eine Signalverarbeitungseinheit (34);
- eine elektronische Einheit zur Erkennung von Raumstrahlung, die elektrisch mit der Signalverarbeitungseinheit (34) verbunden ist;
- mindestens einen Schutzschalter (40), der elektrisch zwischen der elektrischen Masse des Raumelektroniksystems (10) und mindestens einem der Eingangsanschlüsse (300') der empfindlichen elektronischen Schaltung (14) verbunden ist und von der Signalverarbeitungseinheit (34) gesteuert wird; und
- mindestens einen Schutzschalter (52, 24), der elektrisch zwischen der elektrischen Masse des Raumelektroniksystems (10) und mindestens einem der Signalausgangsanschlüsse der empfindlichen elektronischen Schaltung (14) verbunden ist und von der Signalverarbeitungseinheit (34) gesteuert wird, wobei die Signalverarbeitungseinheit (34) so eingerichtet ist, dass sie die mindestens einen Schutzschalter (40, 52, 24) bei der Erkennung einer Amplitude eines Signals, das für die Menge der räumlichen Strahlung repräsentativ ist, die größer als ein vordefinierter Strahlungsschwellenwert ist, an die elektrische Masse schaltet.

2. System (10) nach einem der vorhergehenden Ansprüche, das mindestens einen Stoppschalter (22) umfasst, der elektrisch parallel zu dem mindestens einen Schutzschalter (40) angeordnet ist, der elektrisch zwischen der elektrischen Masse des Raumelektroniksystems (10) und mindestens einem der Signaleingangsanschlüsse der empfindlichen elektronischen Schaltung (14) verbunden ist, wobei die Signalverarbeitungseinheit (34) so eingerichtet ist, dass sie den Stoppschalter (22) bei einer Außerbetriebnahme des empfindlichen elektronischen Schaltkreises (14) an die elektrische Masse schaltet.

3. System (10) nach dem vorhergehenden Anspruch, wobei der mindestens eine Stoppschalter (22) einen bipolaren Transistor aufweist, der so eingerichtet ist, dass er von einem gesperrten elektrischen Zustand in einen elektrischen Zustand geschaltet wird, der in einer Zeit von mehr als hundert Mikrosekunden, vorzugsweise mehr als einer Millisekunde, übergeht.

4. System (10) nach einem der vorhergehenden Ansprüche, wobei die elektronische Einheit zur Erkennung von Raumstrahlung eine elektronische Vorrichtung zur Überwachung des elektrischen Stroms (42) des Signaleingangsanschlusses umfasst.

5. System (10) nach einem der vorhergehenden Ansprüche, wobei die elektronische Einheit zur Erkennung von Raumstrahlung eine elektronische Vorrichtung zur Überwachung der elektrischen Spannung (50) des Signalausgangsanschlusses umfasst.

6. System (10) nach einem der vorhergehenden Ansprüche, bei dem mindestens ein Schutzschalter (40, 52) einen Feldeffekttransistor oder eine Darlington-Montage von zwei bipolaren Transistoren aufweist.

7. System (10) nach einem der vorhergehenden Ansprüche, wobei mindestens ein Schutzschalter (40, 52) so eingerichtet ist, dass er in einer Zeit von weniger als hundert Mikrosekunden, vorzugsweise weniger als zehn Mikrosekunden, von einem gesperrten elektrischen Zustand in einen elektrischen Zustand geschaltet wird.

8. System (10) nach einem der vorhergehenden Ansprüche, bei dem mindestens ein Signaleingangsanschluss eine Stromversorgungsschiene (30) der empfindlichen elektronischen Schaltung (14) ist.

9. Schutzverfahren (100) der empfindlichen elektronischen Schaltung (14) des Raumelektroniksystems (10) nach einem der vorhergehenden Ansprüche, wobei das Schutzverfahren (100) folgende Schritte umfasst:
- Erkennen (110) einer für die Menge der räumlichen Strahlung repräsentativen Signalamplitude über einem vordefinierten Strahlungsschwellenwert;
- Schalten (130) der mindestens einen Schutzschalter (40, 52) an die elektrische Masse.

10. Schutzverfahren (100) nach Anspruch 9, wobei das Raumelektroniksystem (10) mindestens zwei Schutzschalter (40, 52) umfasst, wobei der Schaltschritt (130) das gleichzeitige Schalten (130) jedes der mindestens zwei Schutzschalter (40, 52) an die elektrische Masse umfasst.

11. Testverfahren (200), das eine vordefinierte Lebensdauer des Raumelektroniksystems (10) nach einem der Ansprüche 1 bis 8 gewährleistet, wobei das Testverfahren (200) folgende Schritte am Boden umfasst:
- Senden von eindringenden schweren Ionen (210) oder eindringender Strahlung, die geeignet ist, ein Latch-up auf der empfindlichen elektronischen Schaltung (14) zu erzeugen; und
- Funktionstests (250) des Raumelektroniksystems (10) nach dem Sendeschritt (210) über eine vorbestimmte Dauer und unter thermischer Belastung, die eine beschleunigte Alterung repräsentieren, die der vorbestimmten Lebensdauer des Raumelektroniksystems (10) entspricht, das an Bord eines Satelliten in der Erdumlaufbahn ist.

12. Verfahren (200) nach Anspruch 11, weiter umfassend folgende Schritte am Boden:
- Erfassen (220) der Anzahl von Schaltungen vom gesperrten Zustand in den Übergangszustand von mindestens einem Schutzschalter (40, 52) während des Sendeschritts (210);
- Vergleichen der erfassten Anzahl von Schaltungen mit einer vordefinierten Anzahl Np von Schaltungen an der elektrischen Masse, die repräsentativ für eine geschätzte Anzahl von Schaltungen an der elektrischen Masse ist, die während der vorgegebenen Lebensdauer des elektronischen Systems in seiner räumlichen Umgebung ausgelöst werden können;
- wenn die erfasste Schaltzahl kleiner ist als die vorgegebene Anzahl Np von Schaltungen, wiederholtes und ergänzendes Schalten (230) der Schaltungen des mindestens einen Schutzschalters während des Sende- oder Beschussschritts (210) bis zu einer vorgegebenen Anzahl von Schaltungen an die elektrischen Masse, die repräsentativ für eine geschätzte Anzahl von Schaltungen an der elektrischen Masse ist, die während der vorgegebenen Lebensdauer des elektronischen Systems in seiner räumlichen Umgebung ausgelöst werden können.

13. Verfahren (200) nach Anspruch 11 oder 12, ferner umfassend folgenden Schritt:
- Bestimmen (240) des Zustands der Strukturen der empfindlichen elektronischen Schaltung (14) durch Bildgebung der empfindlichen elektronischen Schaltung (14) nach dem Sendeschritt (210).

## Claims

1. An electronic spatial system (10) including:
- an electronic circuit (14) sensitive to spatial radiations comprising at least one signal input port (300') and at least one signal output port (301), the sensitive electronic circuit (14) being of the electric power supply regulation and stabilization device type;
- a signal processing unit (34);
- an electronic unit for detecting spatial radiations electrically connected to the signal processing unit (34);
- at least one protective switch (40) electrically connected between the electrical ground of the electronic spatial system (10) and at least one amongst the input ports (300') of the sensitive electronic circuit (14), and controlled by the signal processing unit (34); and
- at least one protective switch (52, 24) electrically connected between the electrical ground of the electronic spatial system (10) and at least one amongst the signal output ports of the sensitive electronic circuit (14), and controlled by the signal processing unit (34),
the signal processing unit (34) being configured to switch said at least one protective switch (40, 52, 24) to the electrical ground upon detection of an amplitude of a signal representative of the amount of spatial radiations greater than a predefined radiation threshold.

2. The system (10) according to any one of the preceding claims, comprising at least one cut-off switch (22) arranged electrically in parallel with the at least one protective switch (52) electrically connected between the electrical ground of the electronic spatial system (10) and at least one amongst the signal input ports of the sensitive electronic circuit (14), the signal processing unit (34) being configured to switch the cut-off switch (22) to the electrical ground when turning off the sensitive electronic circuit (14).

3. The system (10) according to the preceding claim, wherein the at least one cut-off switch (22) includes a bipolar transistor configured to be switched from an OFF electrical state into an ON electrical state within a time period greater than one hundred microseconds, preferably greater than one millisecond.

4. The system (10) according to any one of the preceding claims, wherein the spatial radiation detection electronic unit comprises an electronic device for monitoring the electric current (42) of the signal input port.

5. The system (10) according to any one of the preceding claims, wherein the spatial radiation detection electronic unit comprises an electronic device for monitoring the electrical voltage (50) of the signal output port.

6. The system (10) according to any one of the preceding claims, wherein at least one protective switch (40, 52) includes a field-effect transistor or a Darlington pair of two bipolar transistors.

7. The system (10) according to any one of the preceding claims, wherein at least one protective switch (40, 52) is configured to be switched from an OFF electrical state into an ON electrical state within a time period less than one hundred microseconds, preferably less than ten microseconds.

8. The system (10) according to any one of the preceding claims, wherein at least one signal input port is an electric power supply rail (30) of the sensitive electronic circuit (14).

9. A method of protecting (100) the sensitive electronic circuit (14) of the electronic spatial system (10) of any one of the preceding claims, the protection method (100) comprising the steps of:
- detecting (110) an amplitude of the signal representative of the amount of spatial radiations greater than a predefined radiation threshold;
- switching (130) to the electrical ground said at least one protective switch (40, 52).

10. The protection method (100) according to claim 9, the electronic spatial system (10) including at least two protective switches (24, 40), the switching step (130) comprising switching (130) to the electrical ground each of the at least two protective switches (24, 40) simultaneously.

11. A test method (200) ensuring a predefined service life of the electronic spatial system (10) of any one of claims 1 to 8, the test method (200) including the steps on the ground of:
- sending penetrating heavy ions (210) or penetrating radiation capable of creating latch-up on the sensitive electronic circuit (14); and
- functional tests (250) of the electronic spatial system (10) following the sending step (210), for a predetermined time period and under thermal stress representative of an accelerated ageing equivalent to the predefined service life of the electronic spatial system (10) on-board a satellite in Earth orbit.

12. The method (200) according to claim 11, further comprising the steps on the ground of:
- acquiring (220) the number of switchings from the OFF state into the ON state of at least one protective switch (24) during the sending step (210);
- comparing the acquired number of switchings with a predefined number Np of switchings to the electrical ground representative of an estimated number of switchings to the electrical ground that could be triggered over the predefined service life of the electronic system in its spatial environment;
- if the acquired number of switchings is less than the predefined number Np of switchings, switching (230) repeatedly and complementarily to the switchings of the at least one protective switch during the sending or bombardment step (210), up to a predefined number of switchings to the electrical ground representative of an estimated number of switchings to the electrical ground that could trigger during the predefined service life of the electronic system in its spatial environment.

13. The method (200) according to claim 11 or 12, further comprising a step of:
- determining (240) the state of the structures of the sensitive electronic circuit (14) by imaging the sensitive electronic circuit (14) following the sending step (210).
